Europäisches Patentamt

European Patent Office

Office européen des brevets

(11) Publication number: **0 083 499**
**B1**

# EUROPEAN PATENT SPECIFICATION

(45) Date of publication of patent specification: **09.04.86**

(51) Int. Cl.⁴: **C 09 J 7/02, C 09 J 3/14**

(21) Application number: **82306923.2**

(22) Date of filing: **23.12.82**

(54) Hot-tackifying adhesive tape.

(30) Priority: **28.12.81 US 334820**

(43) Date of publication of application:
**13.07.83 Bulletin 83/28**

(45) Publication of the grant of the patent:
**09.04.86 Bulletin 86/15**

(84) Designated Contracting States:
**AT DE FR GB IT NL SE**

(56) References cited:
**DE-B-2 559 997**
**FR-A-1 528 840**

(73) Proprietor: **MINNESOTA MINING AND MANUFACTURING COMPANY**
**3M Center, P.O. Box 33427**
**St. Paul, MN 55133 (US)**

(72) Inventor: **Stow, Robert H.**
**2501 Hudson Road P.O. Box 33427**
**St. Paul Minnesota 55133 (US)**

(74) Representative: **Baillie, Iain Cameron et al**
**c/o Ladas & Parry Isartorplatz 5**
**D-8000 München 2 (DE)**

Courier Press, Leamington Spa, England.

## Description

### Technical field

The invention concerns a heat-activatable adhesive tape that is wound upon itself in roll form for convenience in storage and use and is especially concerned with tapes having adhesive layers which contain electrically-conductive particles.

### Background art

The adhesive layer of most heat-activatable adhesive tapes now on the market has a rather narrow melting point range. Such a tape is called a "hot-melt" adhesive tape, because its adhesive layer is melted at the bonding temperature. At temperatures within 10°C below the bonding temperature, the adhesive may not even be tacky. Because the adhesive has virtually no strength at the bonding temperature, a clamp may be used until a strong bond develops, either by cooling or by curing. If the bond is later heated to a temperature at or above the initial bonding temperature, the bond will fail unless the adhesive has become cured, e.g., by crosslinking. If the adhesive becomes cured when heated, the tape tends to have a limited shelf life, especially if stored in ordinary warehouses which may become quite hot during the day.

Pressure-sensitive adhesive tapes can be formulated to provide immediate bonding strength, usually called "wet-grab". Bonds made therewith tend to retain good strength at moderately elevated temperatures, but may weaken to the point of failure at higher temperatures. One such tape, having a heat-shrinkable backing, is disclosed in U.S. Patent No. 3,718,495 (Tomita). After being wound upon an object as a protective covering, heat is applied to cause the backing to shrink tightly around the object. However, its adhesive layer may become so soft upon further heating that the outermost wrap may become loose.

U.S. Patent No. 3,475,213 (Stow) discloses a pressure-sensitive adhesive tape having an electrically-conductive backing and an adhesive layer containing electrically-conductive metal particles which preferably are flattened. When applied to electrical conductors such as are on one face of a printed circuit board, the particles conduct electricity between the conductors and the backing. Under conditions encountered in use, the particles tend to move about, gradually resulting in increased electrical resistance unless the assembly has a permanent clamp, but this is expensive.

In both of these constructions, hot-tackifying adhesives would find great utility because of the ability thereof to retain bond strengths at elevated temperatures.

### Disclosure of the invention

The invention concerns a heat-activatable adhesive tape that can be wound upon itself in roll form for convenience in storage and use and is nontacky or poorly tacky at ordinary room temperature (20°C), but differs from heat-activatable adhesive tapes of the prior art in that its adhesive layer becomes pressure-sensitive and aggressively tacky when heated. Good bonds are immediately formed at a tackifying temperature without any need for crosslinking or other chemical reactions. Hence, the novel tape may be called a "hot-tackifying" adhesive tape. When later subjected to temperatures at or even above the bonding temperature, adequate bond strength may be retained. Because of this, the novel tape is particularly useful in the tape forms disclosed in the aforementioned Tomita and Stow patents and the below-mentioned Olyphant Patent No. 3,497,383. When the novel tape has a form as disclosed in the Stow patent, the electrically-conductive particles tend to remain in place, and the adhesive is resistant to flow between the particles and the electrical conductors with which they are in adhesive contact, even at elevated temperatures. In such form, the electrically-conductive particles may comprise from 0.1 to 40 volume percent of the adhesive layer.

Like heat-activatable adhesive tapes of the prior art, the hot-tackifying tape of the invention has a flexible, heat-resistant backing. To illustrate, the backing may be a plastic film which may be heat-shrinkable in the lengthwise direction, a conductive metal foil such as copper or aluminum, or a fibrous web such as woven glass fibers. The adhesive layer may incorporate lineally-aligned reinforcing filaments or may contain short, randomly-intermingled fibers or other reinforcing material. Like many adhesive tapes of the prior art, the adhesive layer of the novel tape comprises an acrylic polymer or mixture of acrylic polymers of at least one alkyl acrylate and/or methacrylate ester monomer (here called "acrylic ester monomer") such as ethyl acrylate.

As in the prior art, better cohesive and adhesive strengths are attainable if the adhesive layer comprises an acrylic copolymer or mixture of acrylic copolymers of acrylic ester monomer and at least one copolymerizable monomer having a polar group. Other copolymerizable monomers may also be employed in various amounts without detracting from the value of the acrylic copolymer for the purposes of the invention. Among such copolymerizable monomers are styrene, vinyl acetate and vinyl chloride, which when used are preferably used in amounts up to 5 mol percent of the total monomers.

The adhesive layer of the hot-tackifying tape of the invention differs from adhesive layers of prior heat-activatable tapes in that:

1) the acrylic ester monomer provides at least 50 mol percent of the one or more acrylic polymers of the adhesive layer,

2) the one or more acrylic polymers have a $T_g$ (glass transition temperature) or a weight-averaged $T_g$ of $-10°$ to 80°C,

3) the adhesive layer has:

a) a Probe Tack Value (as defined below) of less than 75 grams of force (gf) at 20°C,

b) Probe Tack Values of at least 75 gf over a range of at least 50°C, which values remain substantially constant after 30 days at 40°C, and

c) a Shear Value (as defined below) of at least 25 minutes at 65°C, and

Optionally up to 50 mol percent of the one or more acrylic polymers can be provided by copolymerizable monomer having a polar group, such as acrylic acid, methacrylic acid, itaconic acid, maleic acid or anhydride, the amides of said acids, acrylonitrile, methacrylonitrile, and N-vinyl-2-pyrrolidone.

The one or more acrylic polymers may be a homopolymer of an acrylic ester monomer which provides a $T_g$ within the range of $-10°$ to 80°C, e.g., methyl acrylate, or a copolymer of acrylic ester monomer and copolymerizable polar monomer having a $T_g$ within that range. Useful acrylic ester monomers which homopolymerize to a $T_g$ of at least $-10°$C include methyl acrylate, methyl methacrylate, ethyl methacrylate, propyl methacrylates, butyl methacrylates, bornyl acrylates, bornyl methacrylates, 2-phenoxyethyl acrylate, 2-phenoxyethyl methacrylate, the mono- and di- methyl and ethyl esters of itaconic acid, and the mono- and di- methyl and ethyl esters of maleic acid. Useful acrylic ester monomers which provide reduced $T_g$ include ethyl, butyl, and octyl acrylates, and n-amyl, hexyl and octyl methacrylates. A copolymer of 43 mol percent of methyl methacrylate, 53 mol percent of methyl acrylate and 4 mol percent of acrylamide had a weight-averaged $T_g$ of about 50°C. A copolymer of 73 mol percent of methyl methacrylate, 19 mol percent of methyl acrylate, 4 mol percent of ethyl acrylate, and 4 mol percent of acrylamide had a weight-averaged $T_g$ of about 79°C. Styrene, vinyl acetate and vinyl chloride may comprise up to 5 mol% of the total monomers.

If the $T_g$ or weight-averaged $T_g$ were below $-10°$C, the adhesive layer might not form bonds having desirable high strength at elevated temperatures, but if above 80°C, bonding temperatures might be undesirably high and the bonds might be unduly brittle at cold temperatures.

When heated about 50°C above its $T_g$ or weight-averaged $T_g$, the adhesive layer becomes sufficiently tacky to form useful bonds with applied pressure. Bonds are more readily made at higher temperatures, preferably near the midpoint of the range of temperatures at which the Probe Tack Value is at least 75 gf. The bonds will retain useful strength at any temperature within the range at which the Probe Tack Value is at least 75 gf.

Typical hot-tackifying tapes of the invention have Probe Tack Values of at least 75 gf over a range of at least 80°C, and in some cases more than 110°C. At any temperature at which the Probe Tack Value is at least 75 gf, the adhesive layer should be sufficiently compliant to adhere well to a clean substrate upon contact without the application of significant pressure. At any temperature at which the Probe Tack Value is substantially less than 75 gf, the adhesive layer is not sufficiently compliant to form good bonds reliably. Because the Probe Tack Values remain substantially constant after 30 days at 40°C, the hot-tackifying tape of the invention can be shipped and stored in commerce and later put to use with the same effect as freshly prepared tape.

The bond-making ability of the hot-tackifying tape can be measured in terms of "shear creep compliance" as in U.S. Patent No. 3,790,439 (LaPerre et al). At ordinary room temperature, the tape has a 10-second shear creep compliance of less than about $0.5 \times 10^{-6}$ cm²/dyne and is too firm to flow out and wet a smooth substrate to form a good bond. At the bonding temperature, the 10-second shear creep compliance should exceed about $1 \times 10^{-6}$ cm²/dyne, above which the adhesive will be soft enough to flow out and wet a smooth substrate to form a good bond.

At the mid-point of the range of temperatures over which the hot-tackifying tape has Probe Tack Values exceeding 75 gf, the 1000-second shear creep compliance should be less than about $5 \times 10^{-5}$ cm²/dyne in order to be sufficiently firm to present adequate resistance to shear forces over long periods of time.

In addition, the novel hot-tackifying acrylic adhesive tape has the advantage over prior tapes in that it can form bonds to inorganic substrates that exhibit surprisingly good resistance to failure upon prolonged exposure to high humidity (e.g., 95% RH) at elevated temperatures (e.g., 80°C), if the acrylic polymer has an interacted functionally reactive organosilane coupling agent in an amount of at least 0.2 part per 100 parts by weight of total monomer. Below about 0.2 part that surprising result is not attained. Best results are attained at about 0.5 to 4 percent. Larger amounts are considered wasteful and might cause short hot life.

The organosilane may be interpolymerized with the acrylic ester monomer, with or without other copolymerizable monomers, or it may be reacted with functional groups on the backbone of an acrylic polymer. Either process results in what is hereinafter called an "acrylic-silane interpolymer".

The organosilane has the general formula $(R_{(4-n)}SiX_n$, where X is a hydrolyzable group such as ethoxy, methoxy, or 2-methoxy-ethoxy; R is a monovalent organic radical of from 1 to 12 carbon atoms which contains a functional organic group such as mercapto, epoxy, acrylyl, methacrylyl, or amino; and n is an integer of from 1 to 3.

As is known in the art, the organosilane can cause solutions of polymers to gel, so that it may be

3

desirable to employ an alcohol or other known stabilizers. When the organosilane is to be copolyerized with the other monomer, a stabilizer should be selected that does not interfere with the polymerization. Methanol is especially useful and is preferably employed in amounts from about twice to about four times the amount of the organosilane.

The backing preferably has low-adhesion surfaces so that the adhesive layer can be removed from the backing.

The backing may be a plastic film and there is an adhesion-promoting primer layer between the adhesive layer and the plastic film. The plastic film may be heat-shrinkable in the lengthwise direction.

A plurality of narrow, parallel electrically-conductive stripes may overlay the plastic film and underlay and contact said adhesive layer.

The adhesive layer may itself be in stripes over-lying each electrically-conductive stripe, and a second unfilled heat-activatable adhesive layer may cover the adhesive stripes and the spaces therebetween, the electrically-conductive particles having thicknesses approximating the total thickness of the two adhesive layers.

An electrically-conductive stripe may underlie each adhesive stripe, the adhesive being filled with electrically-conductive particles comprising 0.1 to 40 volume percent of the adhesive layer.

The backing may be an electrically-conductive metal foil with the adhesive layer in contact with one face of the metal foil. A low-adhesion backside may be coated on the other face of the metal foil.

A carrier web having low-adhesion surfaces may protect the adhesive layer.

The foil may extend in a pattern of lines and/or dots to the surface of the adhesive layer which becomes exposed upon removal of the carrier web.

The backing may be a fibrous web, with the adhesive mechanically interlocked with the fibers at one face of the backing. A suitable material for the backing is woven glass fibers or a web of non-woven fibers. According to another aspect of the present invention there is provided a method of making a hot-tackifying adhesive tape comprising the steps of:

a) polymerizing a composition comprising acrylic ester monomer and functionally reactive organosilane in an amount from 0.2 to 4 parts per 100 parts by weight of total monomer, thus producing an acrylic-silane interpolymer having a $T_g$ of $-10°$ to $80°C$,

b) coating a solution of the interpolymer onto a flexible, heat-resistant backing, and,

c) drying the coating to provide a hot-tackifying adhesive layer which is virtually nontacky at 20°C. Also included within the ambit of the invention is a method of making a hot-tackifying adhesive tape comprising the steps of:

a) polymerizing a composition comprising acrylic ester monomer to provide an acrylic polymer having a $T_g$ of $-10°$ to $80°C$,

b) interacting the acrylic polymer and functionally reactive organosilane in an amount from 0.2 to 4 parts per 100 parts by weight of the polymer,

c) coating a solution of the resulting acrylic-silane interpolymer onto a flexible, heat-resistant backing, and

d) drying the coating to provide a hot-tackifying adhesive layer which is virtually non-tacky at 20°C.

The drawing

In the drawing which schematically illustrates a number of tapes embodying the invention:

Figure 1 shows a roll of one embodiment and an edge of an unwound portion;

Figure 2 is an edge view of a second embodiment;

Figure 3 is an edge view of a third embodiment;

Figure 4 is an end view of a fourth embodiment;

Figure 5 is an end view of a fifth embodiment;

Figure 6 shows the adhesive face of a sixth embodiment; and

Figure 7 is an edge view of a seventh embodiment.

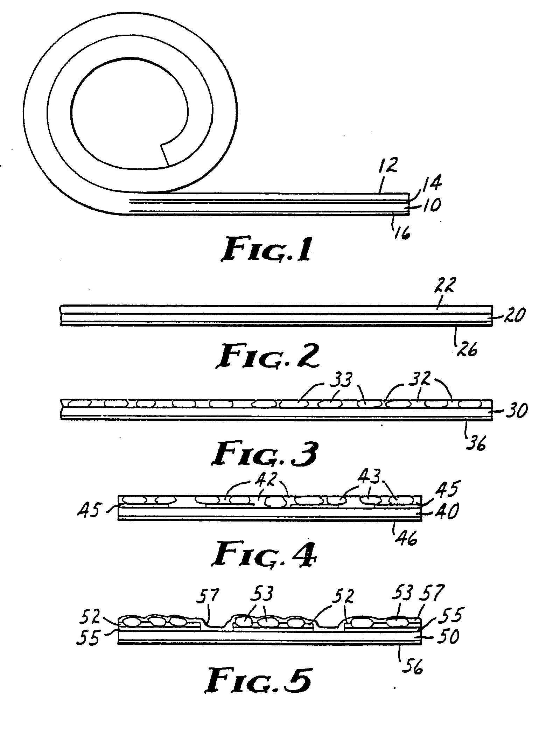

The tape of Figure 1 has a backing 10, a hot-tackifying adhesive layer 12, an adhesion-promoting primer coating 14, and a low-adhesion backsize coating 16. The backing 10 may be a plastic film which may be heat-shrinkable or may be paper. If the backing had a release surface or layer instead of the primer coating 14, the adhesive layer 12 could be removed from the backing for use as a transfer adhesive.

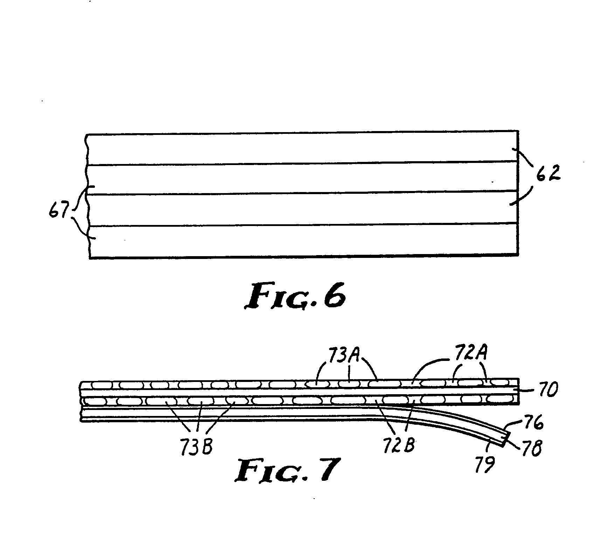

The tape of Figure 2 has a fibrous backing 20 such as paper, cloth or a carded, heat-fused web and a hot-tackifying adhesive layer 22 directly in contact with the backing. Because of the fibrous nature of the backing 20, the adhesive may become mechanically interlocked into interstices of one face of the backing, so that no adhesion-promoting primer layer is necessary. However, a low-adhesion backsize coating 26 (or a disposable liner, not shown) prevents the adhesive layer 22 from becoming mechanically interlocked with the other face of the fibrous backing 20 when the tape is wound upon itself into roll form.

The tape of Figure 3 has an electrically-conductive metal foil backing 30 carrying a layer of hot-tackifying adhesive 32 containing a plurality of electrically-conductive metal particles 33 which preferably are flat as indicated and may have a thickness approximating the overall thickness of the adhesive layer 32. Tapes containing such particles are taught in the aforementioned U.S. Patent No. 3,475,213. No adhesion-promoting primer layer is required inasmuch as the hot-tackifying adhesive layer of the invention tends to adhere strongly to metal backings, but there is a low-adhesion backsize coating 36 to permit unwinding from a roll.

The tape of Figure 4 has a plastic film backing 40 and a layer of hot-tackifying adhesive 42 containing flat electrically-conductive metal particles 43 comparable to the metal particles 33 of Figure 3. The adhesive face of the backing 40 bears four electrically-conductive stripes 45 which may be metal and preferably are thin films and hence of negligible thickness. The opposite face of the backing 40 has a low-adhesion backsize coating 46.

The tape of Figure 5 has a plastic film backing 50 bearing three electrically-conductive stripes 55 similar to those of the tape of Figure 4. Applied over each of the stripes 55 is a stripe of hot-tackifying adhesive 52 containing flat electrically-conductive metal particles 53, the thicknesses of which approximate twice the average dried thickness of the stripes of the adhesive 52. Applied over the adhesive 52 and the spaces between the stripes is a layer of unfilled hot-tackifying adhesive 57, the dried thickness of which approximates that of the adhesive 52. The uncoated face of the backing 50 has a low-adhesion backsize coating 56. When the tape of Figure 5 is heated to a temperature at which the adhesive 57 becomes tacky and is laid against a rigid electrical conductor, pressure against the backing 50 produces electrical contact between the conductor and the conductive stripes 55, the excess adhesives 52 and 57 flowing into the spaces between the stripes.

Figure 6 shows the face of a tape having alternating longitudinal stripes of a hot-tackifying adhesive 62 and an ordinary pressure-sensitive adhesive 67 carried by a backing (not shown). The pressure-sensitive adhesive provides immediate bonding at room temperature, and the strength of the bond is appreciably increased by heating to a temperature at which the adhesive 62 becomes aggressively tacky. The heat-activated bond provided by the hot-tackifying adhesive 62 retains good strength upon subsequent exposure to temperatures at or somewhat above its bonding temperature. Instead of longitudinal stripes, the two types of adhesive could be applied in any desired pattern.

Figure 7 shows the edge of a tape having an electrically-conductive metal foil backing 70 and two layers of hot-tackifying adhesive 72A and 72B, each containing flat electrically-conductive metal particles 73A and 73B, respectively. The double-coated metal foil backing is supported by a disposable carrier web 78 which has low-adhesion surfaces, such as may be provided by a pair of low-adhesion coatings 76 and 79, and is shown being stripped away.

65°C Shear value

Heat a bright annealed stainless steel panel in an oven for 15 minutes at 115°C above the weight-averaged $T_g$ of the adhesive polymer. With the steel panel horizontal, adhere part of a tape 1.27 cm in width to the steel panel using a 2.04-kg hand roller conforming to Federal Standard 147, giving 2 passes in each direction. Trim the length of tape adhering to the panel to exactly 1.27 cm in length and leave this assembly at the bonding temperature for 15 minutes longer. Transfer the plate to an oven having a shear stand which allows a 2° backward tilt of the panel at its top (shear weight will force tape toward panel slightly). After 15 minutes at 65°C, hang a 1-kg weight from the free end of the tape. The time at which the weight falls is the 65°C Shear Value. The test is discontinued if no failure has been detected after a prolonged period, usually 1100 or 1400 minutes.

Probe tack value

The Probe Tack Value is determined as described in ASTM D-2979 except in the following respects:
1. To provide Probe Tack Values at various test temperatures, the probe and the annular weight are heated to the test temperature, except that the annular weight is never heated above 220°C.
2. The probe end is an annulus having inner and outer diameters of 3.83 and 5.10 mm.
3. The annular weight is 19.8 g.
4. Ten-second dwell.

In the following examples, all parts are given by weight, except as noted.

Example 1

An acrylic terpolymer was made by mixing together 36 parts ethyl acrylate, 59 parts methyl acrylate, 5 parts acrylic acid, 286 parts ethyl acetate and 0.1 part azo-*bis*-isobutylnitrile ("Vazo"® 64 catalyst), purging the mixture with nitrogen to remove oxygen, and heating at 53—55°C for 16 hours to give 98—99% conversion to polymer. Weight-averaged $T_g$ of this polymer was 0°C.

After diluting with ethyl acetate and adding .05 part isophthaloyl-*bis*(propylene imine) curing agent per 100 parts solids, this adhesive composition was coated onto one face of a biaxially-oriented polyethylene terephthalate film backing 25 micrometers thick, which face had an adhesion-promoting primer coating as described in U.S. Pat. No. 4,060,664. The opposite face of the film backing had a low-adhesion backsize coating as described in U.S. Pat. No. 2,532,011. After the acrylic polymer coating had been dried and cured a total of 6 minutes at temperatures ranging from 43°C to 104°C to provide a hot-tackifying adhesive tape of the invention, the tape was then slit to a width of 2.54 cm and wound upon itself for storage. The dried thickness of the adhesive layer was 30 micrometers. Test results are reported below:

| | |
|---|---|
| Lowest temperature at which the Probe tack value was 75 gf or more | 50°C |
| Highest temperature at which the Probe tack value was 75 gf or more | 150°C |
| Maximum probe tack value | 364 gf at 110°C |
| Bonding temperature used to prepare for testing 65°C Shear value | 115°C |
| 65°C Shear value in minutes | 1100+. |
| 10-second shear creep compliance at 23°C | $2.2\times10^{-7}$ cm²/dyne |
| 10-second shear creep compliance at bonding temperature | $2.9\times10^{-6}$ cm²/dyne |
| 1000-second shear creep compliance at 100°C | $1.2\times10^{-5}$ cm²/dyne |

Examples 2—9

Additional acrylic terpolymers were made as in Example 1, except with monomer compositions as shown below:

| Example No. | 2 | 3 | 4 | 5 | 6 | 7 | 8 | 9 |
|---|---|---|---|---|---|---|---|---|
| Ethyl acrylate | 68 | 40 | 4 | | | | | |
| Methyl acrylate | 27 | 56 | 91 | 84.6 | 71.7 | | | |
| n-Butyl methacrylate | | | | | | 83 | 68 | 75 |
| Methyl methacrylate | | | | 10.4 | 23.3 | 10 | 25 | 25 |
| Acrylic acid | 5 | | 5 | 5 | 5 | | | |
| Methacrylic acid | | | | | | 7 | 7 | |
| Acrylamide | | 4 | | | | | | |
| Weight-averaged $T_g$ in °C | −10 | 0 | 10 | 20 | 30 | 35 | 46 | 37 |

Tapes were made as in Example 1 using the acrylic terpolymers of Examples 2—6 except that no curing agent was used in the adhesive composition of the tapes of Examples 3 and 9. The tapes of Examples 7—9 were likewise made as described in Example 1 except that the polyester film backing was replaced by dead-soft rolled copper foil (one ounce per square foot or 305 g/m²), a carrier web having low-adhesion surfaces was laid over the adhesive layer, and no curing agent was used in Example 9. Test results are reported below:

| Example No. | 2 | 3 | 4 | 5 | 6 | 7 | 8 | 9 |
|---|---|---|---|---|---|---|---|---|
| Lowest °C, probe tack value 75 gf or more | 23 | 40 | 50 | 60 | 70 | 140 | 150 | 140 |
| Highest °C, probe tack value 75 gf or more | 130 | 140 | 130 | 150 | 160 | 250+ | 250+ | 250+ |
| Maximum probe tack value, gf | 631 | 277 | 609 | 462 | 442 | 476 | 610 | 583 |
| °C at maximum Probe tack value | 50 | 80 | 80 | 90 | 100 | 160 | 160 | 240 |
| Bonding temperature | 115 | 115 | 125 | 135 | 145 | 155 | 165 | 155 |
| 65°C Shear value (minutes) | 1100+ | 97 | 1400+ | 1400+ | 1400+ | 1400+* | 1400+* | 4200+* |

*Tested at 93°C.

Peel adhesions of the tapes of Examples 1 and 4—6 were determined per ASTM-D-1000, except that the stainless steel panel was preheated to the indicated bonding temperature, the roller was under full arm pressure and passed four times in each direction, and the adhesion was tested at the indicated test temperature. The peel adhesions are here repoted in dynes per cm of width times $10^{-5}$.

| Bonding temp °C | 115 | 115 | 115 | 115 | 149 | 149 |
|---|---|---|---|---|---|---|
| Test temp °C | 65 | 121 | 132 | 143 | 163 | 174 |
| Example 1 | 5.1 | 6.4 | 7.3 | 5.1 | 1.5 | 0.5 |
| Example 4 | 5.0 | 5.8 | 6.6 | 5.8 | 2.5 | 0.9 |
| Example 5 | * | 4.9 | 5.0 | 5.0 | 3.2 | 2.1 |
| Example 6 | * | 4.4 | 3.8 | 5.3 | 5.1 | 2.6 |

*No adhesion; shocks off

The tape of Example 3 was also measured as follows:

| 10-second shear creep compliance at 23°C | $3.0 \times 10^{-7}$ cm²/dyne |
|---|---|
| 10-second sheer creep compliance at bonding temperature (115°C) | $3.0 \times 10^{-6}$ cm²/dyne |
| 1000-second sheer creep compliance at 90°C | $8.0 \times 10^{-6}$ cm²/dyne |

Example 10

A tightly woven glass cloth (Style 1290, Burlington Fabrics) was treated by squeeze rolls with a solution made by diluting the adhesive composition of Example 6 to 3% solids with ethyl acetate. Without drying, one face of the cloth was knife-coated with the adhesive composition of Example 1. This tape was dried and cured as in Example 1, then slit to a width of 1.27 cm and wound upon itself for storage. In spite of the adhesive nature of the composition of Example 6, it acted as if it were a low-adhesion backsize coating, thus enabling the tape to be unwound without delamination. After being unwound, it was tested with the following results:

| Probe tack value at 150°C | 241 gf |
|---|---|
| 65°C Shear value | 370 minutes. |

Example 11

A low-adhesion backsize coating was applied to one face of a carded fiber web ("Pellon"® 7605) consisting of a compacted mixture of approximately 70 parts of drawn polyethylene terephthalate fibers and 30 parts amorphous polyethylene terephthalate fibers. To the other face was applied a coating of the adhesive composition of Example 1 followed by drying and curing for 3 minutes at 65°C and then for 3

7

minutes at 104°C. A carrier web having low-adhesion surfaces was laid over the dried adhesive coating, and the whole was wound upon itself for storage.

| | |
|---|---|
| Probe tack value at 60°C | 308 gf |
| 65°C Shear value | 1100+minutes. |

Roll aging was simulated by first bonding at 115°C a 2.54-cm wide strip of the tape to a steel plate and a 1.27-cm wide strip of the tape with its adhesive side against the backing of the first strip. A second steel plate was laid on the top strip, and weights were applied to exert a pressure of approximately 93 gf per cm² against the top strip. After 16 hours at 65°C and cooling to room temperature, the top strip was readily peeled from the bottom strip without any delamination.

Example 12

Fine silver spherical particles were sieved with Tyler sieves, and the cut passing 140 mesh (104 micrometer openings) and held on 170 mesh (89 micrometer openings) was selected. Of this selected powder, 77 g was mixed with 1000 g of vehicle (57 parts low-molecular-weight polyisobutylene and 43 parts mineral oil), flattened in a 3-roll paint mill, and the flattened metal particles were separated and washed with toluene to remove the vehicle. After drying, the silver particles were sieved so that the diameters in the widest direction were all over 104 micrometers. Microscopic examination showed that for this fraction, about 90% of the particles were substantially flattened, 5% were moderately flattened and 5% did not appear to be flattened. All had a thickness of approximately 70 micrometers.

An amount of the adhesive composition of Example 3 containing 100 parts of solids was mixed with 29.5 parts of the flattened silver particles plus 2.8 parts of disalicylalpropylene diamine (E. I. duPont "Copper Inhibitor 50") and 2.4 parts of antioxidant. The mixture was then coated onto a low-adhesion carrier web and dried for a total of six minutes at temperatures ranging from 43°C to 104°C. The thickness of the dried adhesive layer approximated that of the silver particles.

The silver-containing adhesive layer was transferred to dead-soft rolled copper foil (305 g/m²) by rolling from the carrier side at 115°C.

| | |
|---|---|
| Probe tack value at 150°C | 136 gf |
| 65°C Shear value | 25 minutes. |

Resistance was measured by cutting out 1 cm square from a plastic film of 25 micrometers thickness, laying this against dead-soft copper foil, and laying the test tape over the cut-out, with adhesive side down. After heating to 170°C, pressing and cooling, resistance between the two copper foils was less than .001 ohm. After again heating at 90°C for 16 hours, without applying pressure, and cooling to room temperature, the resistance was .001 ohm. All resistance tests were run without applying pressure.

Example 13

The adhesive composition of Example 3 was diluted with ethyl acetate to 19% solids. Then 1 part of disalicylalpropylene diamine and 2.5 parts of antioxidant per 100 parts of adhesive solids were added. This adhesive composition was coated onto dead-soft rolled copper foil (305 g/m²), dried, and interleafed with a carrier web having low-adhesion surfaces.

The carrier web was peeled off and substituted by a similar carrier web which was held in a taut condition and joined to the adhesive layer between the nip of two heated steel rolls. The roll contacting the carrier web was smooth, and the other roll had an embossing pattern consisting of 2 sets of raised fine lines on centers of 1.59 mm, the 2 sets being at right angles to each other, leaving a pattern of depressed squares on the embossing roll as illustrated in Figure 3 of U.S. Patent No. 3,497,383 (Olyphant, Jr. et al.). All the raised lines ran in a direction inclined 45° to the direction of rotation, so that diagonals of the squares were in the direction of rotation. While both rolls were at 280°C, they were pressed together with a gauge pressure of 2100 g/cm² distributed across the 25-cm wide web, thus creating the fine lines in the copper foil which reached the surface of the adhesive at the carrier web. The whole was slit to a width of 2.54 cm and wound up for storage. After peeling off the carrier web, the foil-backed tape was shown to effectively shield against radio-frequency signals without need for a clamp to hold it in place.

Example 14

Fine annealed spherical copper particles were sifted to pass 200 mesh (74 micrometer openings) and be held on 230 mesh (63 micrometer openings) and then flattened and again sifted as in Example 12. About 85% of the particles were substantially flattened, 10% moderately flattened and 5% not flattened. All had a thickness of approximately 48 micrometers.

An amount of the adhesive of Example 3 containing 100 parts solids was mixed with 24 parts of the flattened copper particles plus 2.8 parts of disalicylalpropylene diamine and 2.4 parts of antioxidant. This was coated onto dead-soft rolled copper foil (305 g/m²) and dried 75 seconds at 57°C and 75 seconds at 127°C to a thickness approximating that of the copper particles. A disposable carrier web having low-adhesion surfaces was laid over the dried coating, and the whole was slit to widths of 2.5 cm and wound up for storage.

| | |
|---|---|
| Probe tack value at 150°C | 179 gf |
| 65°C Shear value | 34 minutes |
| Resistance, fresh (as in Example 12) | below .001 ohm per cm$^2$ |
| Resistance, aged 16 hours at 90°C and cooled | .001 ohm per cm$^2$ |

Example 15

Biaxially-oriented polyethylene terephthalate film which had 53% shrinkage in the lengthwise direction when heated to 150°C was primed and backsized as in Example 1. It was then coated on the primed side with the adhesive of Example 1, and dried 6 minutes at 65°C, higher temperatures being avoided to keep shrinking the film during drying. This was slit to tapes 2.54 cm in width which were wound upon themselves. A steel gear, 1.27 cm wide by 3.02 cm in diameter at the tips of the teeth and 2.11 cm in diameter between the teeth, was heated to 70°C and wrapped circumferentially with the tape to provide a .63 cm long overlap, ending on the flat face of a tooth. The wrapped gear was then heated with an air gun, shrinking the tape snugly around the gear, with the tape attached firmly and evenly to the sides of the gear.

| | |
|---|---|
| Probe tack value at 110°C | 358 gf |
| 65°C Shear value | 1400+minutes |

Example 16

A hot-tackifying tape of the invention was made using as the backing biaxially-oriented polyethylene terephthalate film of 25 micrometers thickness which had been heat-treated to develop superior thermal dimensional stability. Metallic silver stripes were applied by vapor deposition to a thickness of 25 nm and a width of 0.89 mm on 1.78 mm centers.

An acrylic terpolymer was made as in Example 1, except that the monomer composition was 10.4 parts methyl methacrylate, 85.6 parts methyl acrylate, and 4.0 parts acrylamide. Its weight-averaged $T_g$ was 20°C. The hot-tackifying acrylic terpolymer adhesive was mixed with flattened silver metal particles having diameters from 76 to 102 micrometers and thicknesses about 25 micrometers. The particles comprised about 8% by volume of the mixture which was coated through a mask in stripes in register with the vapor-deposited silver stripes. Each adhesive stripe was about 13 micrometers in thickness after drying. Then the hot-tackifying adhesive of Example 3 was coated uniformly over the entire striped face and dried to a thickness of about 13 micrometers. At the same time a low-adhesion backsize was applied to the other face of the tape. This was slit to widths of 2.54 cm, each tape having 17 pairs of silver metal stripes and silver-particle-filled adhesive stripes. The tapes were wound upon themselves into rolls.

A piece of the tape 3.7 cm in length was applied to an unheated printed circuit board using a press, the moving platen of which was preheated to 170°C. Each pair of stripes of the tape matched a conductive lead on the face of the circuit board (adhered length 0.6 cm). A pressure of 119 kgf/cm$^2$ was applied for 5 seconds. The other end of the piece of tape was applied in the same way to an unheated indium-tin oxide coating on glass (adhered length 0.6 cm). After cooling to room temperature, the average resistance per channel was 237 ohms. After aging at 90°C for 619 hours and cooling to room temperature, the resistance per channel increased to 350 ohms. This rather modest increase in resistivity suggests that good electrical conductivity should be retained after prolonged periods of use during which the adhesive may become rather warm due to electrical conduction and other phenomena.

The outer adhesive material, because of its lower $T_g$, enables adhesive bonding at lower temperatures than would an adhesive layer composed only of the inner adhesive material. However, the presence of the inner adhesive material enhances high-temperature performance.

Example 17

A resist solution was made by mixing 800 grams of polystyrene resin, 160 grams of dioctylphthalate, 1222 grams of toluene, 2 grams of oil soluble blue dye, and 6 grams of oil soluble yellow dye. This solution was coated through a mask with slots, each 0.53 mm wide on 1.79 mm centers, onto unprimed, backsized, biaxially-oriented polyethylene terephthalate film 25 micrometers thick which had been heat-treated to develop superior thermal dimensional stability. After drying to provide a striped resist pattern, about 5 nm of silver were deposited by vapor coating, covering both the resist stripes and the spaces between them. The resist was then pulled away, leaving a pattern of vapor-deposited silver stripes. The striped polyester film was then heated for 10 minutes at 150°C to anchor the silver more securely.

A solution of the adhesive of Example 3 was diluted to 25% solids, and mixed with small amounts of oil-soluble dyes plus 2.96 parts disalicylalpropylene diamine and 2.6 parts antioxidant per 100 parts adhesive solids. Just before coating, this was mixed with 50.2 parts per 100 parts adhesive solids of flattened spherical silver that passed through a 140 mesh Tyler sieve (104 micrometer openings) and was retained on a 200 mesh Tyler sieve (74 micrometer openings). While being stirred vigorously, this was coated onto the silvered side of the polyester film using the same mask to apply an adhesive stripe over each silver stripe. After drying, the double-striped tape was wound up with a liner for storage. Its adhesive stripes were between 25 and 30 micrometers thick and silver particles protruded above the mean adhesive surface 6 to 13 micrometers. The silver particles comprised about 4.8 volume percent of the adhesive layer. Peel adhesion from glass according to ASTM D-1000 (except for substrate and bonding method) was between 5.2 and $7.9 \times 10^{-5}$ dynes per cm of width (including gaps between the adhesive stripes).

The tape was tested by bonding it (as in Example 16 except at 4.2 kgf/cm$^2$) to a circuit board which had 17 channels provided by strips of solder-covered copper foil, each about 0.9 mm wide on 1.79 mm centers. There was a 2.54 cm gap in the lengthwise direction in these strips, and the tape was applied so that each pair of adhesive and vapor-coated stripes bridged the gap in each strip of copper foil.

The following test results are averages of measuring each of the 17 channels at room temperature:

After 6000 hours at 70°C, resistance per channel rose from an average initial value of 8 ohms to an average of 13 ohms.

After thermal cycling for 6000 hours between −40°C and 70°C, using a 4-hour cycle, with one hour at each temperature and 2 hours at intermediate temperatures, resistance per channel rose from 7.5 ohms initially to 14 ohms.

After a humidity soak for 6000 hours at 90% relative humidity and 50°C, resistance rose from an initial value of 7.5 ohms to 14 ohms.

Example 18

Biaxially-oriented polyethylene terephthalate film was primed and backsized as in Example 1, and then coated in stripes with a solution of the hot-tackifying acrylic terpolymer of Example 16 containing blue dye. The stripes were each approximately 0.89 mm wide, on 1.78 mm centers. After drying, a solution of a pressure-sensitive adhesive was coated in stripes between the stripes of the adhesive terpolymer. The pressure-sensitive adhesive comprised by weight 44.2% natural rubber, 8.84% ZnO, 1.87% carbon black, 8.84% wood rosin, 26.52% polyterpene resin softening at 115°C, 8.84% heat-reactive phenolic resin and 0.88% antioxidant. After drying of the pressure-sensitive adhesive coating, the resultant tape was slit and wound into rolls 2.54 cm wide.

Peel adhesions determined according to ASTM D-1000 (except for application and testing temperatures) were:

| | |
|---|---|
| Applied at 20°C, tested at 20°C | 340 gf/cm |
| Applied at 115°C, tested at 20°C | 1248 gf/cm |
| Applied at 115°C, tested at 65°C | 817 gf/cm |

Example 19

Biaxially-oriented polyethylene terephthalate polyester film 25 micrometers in thickness was heat-treated to develop superior thermal dimensional stability. Silver stripes were vapor-deposited 0.89 mm wide and approximately 100 nm thick.

Into a solution of the adhesive of Example 3 was mixed per 100 parts adhesive solids 8 parts by volume of flattened silver particles, 76 micrometers to 102 micrometers in diameter and approximately 25 micrometers thick. While being stirred vigorously, this was coated onto the silvered side of the polyester film to a dried thickness of approximately 25 micrometers.

A piece of the resulting hot-tackifying adhesive tape 3.1 cm in length was bonded at one end to a conductive indium-tin oxide coating on glass and at the other end to a printed circuit board (as in Example 16 except at 11.9 kg/cm$^2$). The board had electrically conductive channels at the same spacing as the vapor-coated stripes of the tape so that each adhesive stripe connected one channel to the indium-tin oxide coating through 2.54 cm of unbonded tape. Initial resistance per channel through the two adhesives bonds was 255 ohms at room temperature. After 431 hours at 90°C, the resistance at room temperature was 437 ohms.

Example 20

Used in this Example was a carrier web having low-adhesion surfaces, one having greater affinity to acrylate adhesives than the other. The adhesive composition of Example 1 was coated over the surface of greater affinity and dried and cured 2 minutes at 50°C, 2 minutes at 80°C and 4 minutes at 95°C. After cooling, this hot-tackifying adhesive tape was slit to widths of 1.27 cm and wound up for storage.

The adhesive layer was transferred to dead-soft rolled copper foil (305 g/m$^2$) by rolling from the carrier side at 115°C. The resulting copper-foil backed tape was tested as follows:

10

Probe tack value at 60°C    225 gf

65°C Shear value    1100+minutes

90° Static peel value

One-half-inch by 3-inch (1.27 by 7.62 cm) test specimens are bonded in a heated platen press by their adhesive layers to glass plates, leaving one inch (2.54 cm) of each specimen unbonded. The platens are heated to 200°C, and 200 psi (1378 kPa) is applied for ten seconds. The actual temperature to which the adhesive is heated may be 40 or 50°C below the platen temperature. The glass plates are immediately positioned horizontally in a test fixture, a 100-gram weight is hung from the unbonded portion of the specimen, and the fixture is placed in a humidity changer at 80°C and 95% R.H. The time for the weight to fall is recorded as the 90° Static Peel Value. All reported values are averages of at least three specimens.

180° Dynamic peel value

Specimens prepared in the same manner as for the 90° Static Peel Value are tested for 180° peelback on a Twing Albert tensile tester ("Intelect® 500") at a jaw separation rate of 0.1 inch/min (0.25 cm/min). Initial values are determined within 30 minutes at room temperature. After being held in a humidity chamber, the specimens are removed and tested within 30 minutes at room temperature. All reported values are averages of at least three specimens.

Acrylic-silane interpolymer A

To a 250 ml polyethylene bottle was charged 22.4 g of ethyl acrylate, 31.36 g of methyl acrylate, 1.68 g of acrylamide, 0.56 g of gamma-methacryloxypropyltrimethoxysilane, 0.112 g of azobis(isobutyronitrile) and 144 g of ethyl acetate. (Based on solids weight the monomer charge consisted of 36.5 mol percent ethylacrylate, 59.3 mol percent methylacrylate, 3.8 mol percent acrylamide, and 0.4 mol percent of the functionally reactive organo silane). The bottle was purged three times with nitrogen, capped and placed in a water bath at 60°C for about 16 hours. The percent conversion of monomers to polymer was determined by infrared spectrophotomeric analysis to be 98.8. The weight-average $T_g$ of the polymer was 0°C. The inherent viscosity was 1.49 determined using 0.1 g of polymer in 100 ml of ethyl acetate.

Acrylic-silane interpolymers B-H

The same polymerization procedure was followed as in making Acrylic-silane Interpolymer A except as indicated in Table I, and the organosilane used in making Acrylicsilane Interpolymer D was gamma-methacryloxypropyl-tris-(2-methoxyethoxy) silane.

TABLE I

|  | B | C | D | E | F | G | H |
|---|---|---|---|---|---|---|---|
| Methyl acrylate (g) | 47.4 | 31.02 | 31.36 | 29.5 | 29.5 | 45.6 | 45.6 |
| Methyl methacrylate (g) | 9.0 | 31.02 |  | 1.5 | 1.75 | 13.8 | 14.1 |
| Ethyl acrylate (g) |  |  | 22.4 | 18.5 | 18.5 |  |  |
| Acrylamide (g) | 3.0 | 2.3 | 1.4 |  |  |  |  |
| Organosilane (g) | 0.6 | 0.66 | 0.84 | 0.5 | 0.25 | 0.6 | 0.3 |
| Azobis(isobutyronitrile) (g) | 0.12 | 0.132 | 0.112 | 0.1 | 0.1 | 0.12 | 0.12 |
| Ethyl acetate (g) | 140 | 134 | 144 | 150 | 150 | 140 | 140 |
| Bath temperature (°C) | 53 | 53 | 60 | 63 | 63 | 53 | 53 |
| time (hours) | 20 | 20 | 16 | 16 | 16 | 20 | 20 |
| Conversion to polymer (%) | 97.6 | 96.4 | 98.3 | 100 | 99.8 | 99.8 | 98.9 |
| Inherent viscosity | 1.29 | 1.12 | 1.48 | 1.485 | 1.45 | 1.50 | 1.46 |
| Approx. $T_g$ (°C) | 30 | 60 | 0 | 0 | 0 | 30 | 30 |

Acrylic-silane interpolymer I

A 500 ml polyethylene bottle was charged with 18.48 g of ethyl acrylate, 32.64 g of methyl acrylate, 4.5 g of methyl methacrylate, 0.392 g of isocyanatoethyl methacrylate, 0.112 g of azobis(isobutyronitrile) and 144 g of ethyl acetate. (Based on solids weight the monomer charge consisted of 30.3 mol percent ethyl acrylate, 62.0 mol percent methyl acrylate, 7.4 mol percent methyl methacrylate, and 0.4 mol percent isocyanatoethyl methacrylate.) After purging three times with nitrogen, the bottle was capped and placed in a constant temperature bath at 53°C for 24 hours. To the resulting polymer solution was added 2.2 g of gamma-aminopropyltriethoxysilane in 90 g of ethyl acetate in four additions over a period of 2 hours. The mixture was shaken for an additional 10 hours. No gellation was evident after this time. An infrared spectrum of the polymer solution showed a 96.9 percent conversion of monomer to polymer and no isocyanate group. Inherent viscosity, 1.48; $T_g$, 0°C.

Acrylic-silane interpolymer J

The 2-step procedure used in making Acrylic Copolymer I was followed using a charge of 18.48 g of ethyl acrylate, 32.88 g of methyl acrylate, 4.48 g of methyl methacrylate, 0.168 g of acrylic acid, 0.112 g of azobis(isobutyronitrile), and 144 g of ethyl acetate. (Based on solids weight, the monomer charge consisted of 30.1 mol percent ethyl acrylate, 62.2 mol percent methyl acrylate, 7.3 mol percent methyl methacrylate, and 0.4 mol percent acrylic acid.) After 24 hours at 53°C, was added 2.4 g of gamma-glycidoxypropyltrimethoxysilane in 90 g of ethyl acetate. After shaking for about 72 hours, no gellation was evident, and an infrared spectrum of the polymer solution showed a 97.9 percent conversion of monomer to polymer. Inherent viscosity, 1.37; $T_g$, 0°C.

Examples 21—30

Each of the solutions of Acrylic-silane Interpolymers A-J was diluted with ethyl acetate to easily coatable viscosities within the range of 2,000 to 10,000 cps (Brookfield). Percent solids of each was 15—20% by weight. Using a knife coater at a knife setting of 0.15 mm each was coated onto a nonwoven web ["Webril"® Grade 1302, 27 g/yd$^2$ (32 g/m$^2$), Kendall Fiber Products Div.] of drawn polyethylene-terephthalate fibers which had previously been saturated with a rubbery thermoset acrylic resin. After 15 minutes at 80°C in an air-circulating oven to dry the coating, an identical second coating was applied over the first to provide a total dry coating thickness of 0.06 mm. 180° Dynamic Peel Values are reported in Table II for the tapes of Examples 21—30, together with Comparative Examples 21(c) and 22(c) which were identical to Examples 21 and 22, respectively, except for omission of the organosilane when making the acrylic polymers.

TABLE II
180° Dynamic peel values in newtons per dm width

| Ex. No. | Acrylic-silane interpolymer | Initial | After aging at 80°C, 95% R. H. | | | |
| --- | --- | --- | --- | --- | --- | --- |
| | | | 24 hr. | 200 hr. | 600 hr. | 1000 hr. |
| 1 | A | 74 | 166** | 149** | 124 | 70 |
| 1(c) | | 26 | 0 | NT | nT | NT |
| 2 | B | 119 | 145** | 105* | 93* | 105* |
| 2(c) | | 0 | NT | NT | NT | NT |
| 3 | C | 82* | 89* | 94* | 91* | 81* |
| 4 | D | 39 | 95 | 73 | 58 | 44 |
| 5 | E | 77 | 123** | 82* | 80* | 63* |
| 6 | F | 54 | 109* | 105** | 65* | 49** |
| 7 | G | 119* | 61* | 60* | 60* | 57* |
| 8 | H | 106 | 79* | 65* | 64* | 58* |
| 9 | I | 67 | 142 | 132* | 110* | 107* |
| 10 | J | 60 | 137 | 154* | 169* | 179* |

NT=not tested
Failures, adhesive except as indicated by:
   * cohesive or backing failure
   ** combined adhesive and cohesive or backing failure

# 0 083 499

Each of the tapes of Examples 21—24, 29 and 30 has a 90° Static Peel Value exceeding 240 minutes, at which point the test was discontinued. The tape of Example 21(c) failed at 0.22 min. and the tape of Example 22(c) failed at less than 0.1 min. Examples 25—28 were not tested.

Example 31

A hot-tackifying tape of the invention was made using as the backing biaxially-oriented polyethylene terephthalate film of 25 micrometers thickness which had been heat-treated to develop superior thermal dimensional stability. Metallic silver stripes were applied by vapor deposition to a thickness of 25 nm and a width of 0.89 mm on 1.78 mm centers.

The solution of Acrylic-silane Interpolymer A was diluted with ethyl acetate to a coatable viscosity and then mixed with flattened silver metal particles having diameters from 76 to 102 micrometers and thicknesses about 25 micrometers. The particles comprised about 8% by volume of the mixture which was coated through a mask in stripes in register with the vapor-deposited silver stripes. Each adhesive stripe was about 13 micrometers in thickness after driving. Then the unfilled coatable solution of Acrylic Copolymer A was coated uniformly over the entire striped face and dried to a thickness of about 13 micrometers. This was slit into tapes having a width of 2.54 cm, each tape having ten silver metal stripes and matching silver-particle-filled adhesive stripes. The tapes were wound upon themselves into rolls.

A piece of the tape 3.7 cm in length was applied to an unheated printed circuit board using a press, the moving platen of which was preheated to 170°C. Each pair of stripes of the tape matched a conductive lead on the face of the circuit board (adhered length 0.6 cm). A pressure of 1340 kPa/cm² was applied for 5 seconds. The other end of the piece of tape was applied in the same way to an unheated indium-tin oxide coating on glass (adhered length 0.32 cm). The pressure in each case reduced the overall adhesive thickness to less than the thicknesses of the silver metal particles, thus creating an electrically-conductive path between the indium-tin oxide coating and each conductor of the printed circuit. After cooling to room temperature, the average resistance in each such path was 50 ohms. After 1000 hours at 90°C, the resistance had not increased.

Example 32

The solution of Acrylic-silane interpolymer B was diluted with ethyl acetate to 15.5% solids. Then 1.9 part of disalicylalpropylene diamine and 2.3 parts of antioxidant per 100 parts of adhesive solids were added. This was coated onto dead-soft rolled copper foil (305 g/m²), dried, and interleafed with a carrier web having low-adhesion surfaces.

The carrier web was peeled off and substituted by a similar carrier web which was held in a taut condition and joined to the adhesive layer between the nip of two heated steel rolls. The roll contacting the carrier web was smooth, and the other roll had an embossing pattern consisting of 2 sets of raised fine lines on centers of 1.59 mm, the 2 sets being at right angles to each other, leaving a pattern of depressed squares on the embossing roll as illustrated in Figure 3 of U.S. Patent No. 3,497,383 (Olyphant, Jr. et al.). All the raised lines ran in a direction inclined 45° to the direction of rotation, so that diagonals of the squares were in the direction of rotation. While both rolls were at 249°C, they were pressed together with a gauge pressure of 2800 g/cm² distributed across the 25-cm wide web, thus creating fine lines in the copper foil which reached the surface of the adhesive at the carrier web. The whole was slit to a width of 2.54 cm and wound up for storage. After peeling off the carrier web, the hot-tackifying adhesive layer of a piece of the resulting tape 2.5 inches (6.35 cm) in length was laid against two copper foil specimens such that a one-inch (2.54 cm) length at each end of the tape contacted copper with a 0.5 inch (1.27 cm) gap between the two copper specimens. Bonds to the copper specimens were made on a hot plate at 121°C under three passes of a hard-rubber roller using full arm pressure. After cooling, the resistance between the two copper foil specimens was 0.2 ohm.

## Claims

1. Heat-activatable adhesive tape that can be wound upon itself in roll form for convenience in storage and use and comprises a heat-resistant flexible backing and an adhesive layer which is nontacky or poorly tacky at 20°C, said adhesive layer comprising one or more acrylic polymers of acrylic ester monomer, characterized in that

1) acrylic ester monomer provides at least 50 mol percent of the one or more acrylic polymers of the adhesive layer,

2) said one or more acrylic polymers have a $T_g$ or a weight-averaged $T_g$ of −10° to 80°C, and

3) said adhesive layer has

a) a Probe Tack Value of less than 75 gf at 20°C,

b) Probe Tack Values of at least 75 gf over a range of at least 50°C, which values remain substantially constant after 30 days at 40°C, and

c) A Shear Value of at least 25 minutes at 65°C, said adhesive layer adheres well to a clean substrate upon contact at any temperature within said 50°C range;

wherein acrylic ester monomer is defined as alkyl acrylate and/or methacrylate ester monomer.

2. An adhesive tape according to claim 1, said adhesive layer comprising an acrylic-silane interpolymer

13

of primarily acrylic ester monomer interacted with organosilane in an amount of at least 0.2 part per 100 parts by weight of total monomer; wherein acrylic-silane interpolymer is defined as either of the products obtained when the organosilane is interpolymerized with the acrylic ester monomer, with or without other copolymerizable monomers, or when it is reacted with functional groups on the backbone of an acrylic polymer.

3. An adhesive tape as defined in claim 2 wherein the amount of organosilane is from 0.5 to 4 parts per 100 parts by weight of total monomer.

4. An adhesive tape as defined in any one of claims 1 to 3 wherein said adhesive layer comprises one or more acrylic copolymer of monomers, up to 50 mol% of which is at least one copolymerizable monomer selected from acrylic acid, methacrylic acid, itaconic acid, maleic acid, maleic anhydride, amides of said acids, acrylonitrile, methacrylonitrile, and N-vinyl-2-pyrrolidone.

5. An adhesive tape as defined in any one of claims 1 to 4 wherein said acrylic ester monomer is selected from alkyl acrylates having 1—8 carbon atoms in their alkyl groups, alkyl methacrylates having 1—8 carbon atoms in their alkyl groups, bornyl acrylates, bornyl methacrylates, 2-phenoxyethyl acrylate, 2-phenoxyethyl methacrylate, the mono- and di- methyl and ethyl esters of itaconic acid, and the mono- and di- methyl and ethyl esters of maleic acid.

6. An adhesive tape as defined in any one of claims 1 to 5 wherein styrene, vinyl acetate and vinyl chloride comprise up to 5 mol% of the total monomers.

7. An adhesive tape as defined in any one of claims 1 to 6 wherein said adhesive layer has Probe Tack Values of at least 75 gf over a range of at least 80°C.

8. An adhesive tape as defined in any one of claims 1 to 7 wherein said backing has low-adhesion surfaces so that the adhesive layer can be removed from the backing.

9. An adhesive tape as defined in any one of claims 1 to 8 wherein said adhesive layer consists of spaced stripes of said one or more polymers.

10. Heat-activatable adhesive tape as defined in claim 9 wherein the spaces between said spaced stripes are filled with stripes of a pressure-sensitive adhesive.

11. An adhesive tape as defined in any one of claims 1 to 10 wherein the adhesive is filled with electrically-conductive particles comprising 0.1 to 40 volume percent of the adhesive layer.

12. An adhesive tape as defined in any one of claims 1 to 11 wherein said backing is a plastic film and there is an adhesion-promoting primer layer between the adhesive layer and the plastic film.

13. An adhesive tape as defined in claim 12 wherein the plastic film is heat-shrinkable in the lengthwise direction.

14. An adhesive tape as defined in any one of claims 1 to 13 wherein said backing is a plastic film, and a plurality of narrow, parallel electrically-conductive stripes overlay the plastic film and underlay and contact said adhesive layer.

15. Heat-activatable adhesive tape as defined in claim 14 wherein said adhesive layer is in stripes over-lying each electrically-conductive stripe, and a second unfilled heat-activatable adhesive layer covers the adhesive stripes and the spaces therebetween, the electrically-conductive particles having thicknesses approximating the total thickness of the two adhesive layers.

16. Heat-activatable adhesive tape as defined in any one of claims 1 to 15 wherein said backing is a plastic film, there is an electrically-conductive stripe underlying each adhesive stripe, and the adhesive is filled with electrically-conductive particles comprising 0.1 to 40 volume percent of the adhesive layer.

17. Heat-activatable adhesive tape as defined in any one of claims 1 to 11 wherein said backing is an electrically-conductive metal foil.

18. An adhesive tape as defined in claim 17 wherein the adhesive layer is in contact with one face of the metal foil, and there is a low-adhesion backside coating on the other face of the metal foil.

19. An adhesive tape as defined in either of claims 17 or 18 wherein a carrier web having low-adhesion surfaces protects the adhesive layer.

20. An adhesive tape as defined in claim 19 wherein the foil extends in a pattern of lines and/or dots to the surface of the adhesive layer which becomes exposed upon removal of the carrier web.

21. An adhesive tape as defined in any one of claims 1 to 11 wherein said backing is a fibrous web, the adhesive is mechanically interlocked with the fibers at one face of the backing.

22. An adhesive tape as defined in claim 21 wherein the backing comprises woven glass fibers or a web of non-woven fibers.

23. Method of making a hot-tackifying adhesive tape comprising the steps of:

a) polymerizing a composition comprising acrylic ester monomer and functionally reactive organosilane in an amount from 0.2 to 4 parts per 100 parts by weight of total monomer, thus producing an acrylic-silane interpolymer having a $T_g$ of −10° to 80°C,

b) coating a solution of the interpolymer onto a flexible, heat-resistant backing, and,

c) drying the coating to provide a hot-tackifying adhesive layer which is virtually nontacky at 20°C.

24. Method of making a hot-tackifying adhesive tape comprising the steps of:

a) polymerizing a composition acrylic ester monomer to provide an acrylic polymer having a $T_g$ of −10° to 80°C,

b) interacting the acrylic polymer and functionally reactive organosilane in an amount from 0.2 to 4 parts per 100 parts by weight of the polymer,

14

c) coating a solution of the resulting acrylic-silane interpolymer onto a flexible, heat-resistant backing, and

d) drying the coating to provide a hot-tackifying adhesive layer which is virtually non-tacky at 20°C.

**Patentansprüche**

1. Wärmeaktivierbares Klebeband, des zur Vereinfachung seiner Lagerung und Verwendung zu einer Rolle aufgewickelt werden kann und eine hitzebeständige, flexible Tragschicht und eine Klebstoffschicht besitzt, die bei 20°C nicht klebfähig oder nur schwach klebfähig ist und die ein oder mehrere Acrylsäurepolymere aus Acrylsäureestermonomer enthält, dadurch gekennzeichnet, daß

1) des oder die Acrylsäurepolymere der Klebstoffschicht zu mindestens 50 Molprozent aus Acrylsäureestermonomer bestehen;

2) das oder die Acrylsäurepolymere eine Einfriertemperatur oder eine gewichtsdurchschnittliche Einfriertemperatur von −10 bis 80°C haben; und

3) die Klebstoffschicht

a) eine Sondenklebrigkeit von weniger als 75 p bei 20°C und

b) Sondenklebrigkeiten von mindestens 75 p in einem Bereich von mindestens 50°C besitzt, wobei diese Werte bei 40°C mindestens 30 Tage lang konstant bleiben, und

c) eine Scherfestigkeit von mindestens 25 Minuten bei 65°C besitzt, wobei die Klebstoffschicht bei jeder Temperatur in dem genannten Bereich von 50°C an einem sauberen Substrat gut haftet, wobei das Acrylsäureestermonomer ein Alkylacrylat- und/oder ein Alkylmethacrylatmonomer ist.

2. Klebstreifen nach Anspruch 1, dadurch gekennzeichnet, daß die Klebstoffschicht ein Acrylsäure-Silan-Interpolymer enthält, das vorwiegend aus Acrylsäureesterpolymer besteht, das mit einem Organosilan in einer Menge von mindestens 0,2 Teil pro 100 Gewichtsteile Gesamtmonomer in Wechselwirkung gebracht worden ist, wobei das Acrylsäuresilan-Interpolymer eines der Produkte ist, die erhalten werden, wenn das Organosilan mit dem Acrylsäuremonomer mit oder ohne andere copolymerisierbere Monomere interpolymerisiert wird, oder wenn es mit funktionellen Gruppen an der Hauptkette eines Acrylsäurepolymers umgesetzt wird.

3. Klebeband nach Anspruch 2, dadurch gekennzeichnet, daß die Menge des Organosilans 0,5 bis 4 Teile pro 100 Gewichtsteile Gesamtmonomer beträgt.

4. Klebeband nach einem der Ansprüche 1 bis 3, dadurch gekennzeichnet, daß die Klebstoffschicht ein oder mehrere Acrylsäurecopolymere von Monomeren enthält, die zu bis zu 50 Molprozent aus mindestens einem copolymerisierbaren Monomer bestehen, das aus der Acrylsäure, der Methacrylsäure, der Itaconsäure, der Maleinsäure, dem Maleinsäureanhydrid, dem Amiden der genannten Säuren, dem Acrylnitril, dem Methacrylnitril und dem N-Vinyl-2-pyrrolidon ausgewählt ist.

5. Klebeband nach einem der Ansprüche 1 bis 4, dadurch gekennzeichnet, daß das Acrylsäureestermonomer ausgewählt ist aus den Alkylacrylaten mit 1 bis 8 Kohlenstoffatomen in ihren Alkylgruppen, den Alkylmethacrylaten mit 1 bis 8 Kohlenstoffatomen in ihren Alkylgruppen, den Bornylacrylaten, den Bornylmethacrylaten, den 2-Phenoxyethylacrylat, dem 2-Phenoxyethylmethacrylat, den Mono- und Di-methyl- und -ethyl-estern der Itaconsäure und den Mono- und Di-methyl- und -ethylestern der Maleinsäure.

6. Klebeband nach einem der Ansprüche 1 bis 5, dadurch gekennzeichnet, daß das Gesamtmonomer zu bis zu 5 Molprozent aus Styrol, Vinylacetat und Vinylchlorid besteht.

7. Klebeband nach einem der Ansprüche 1 bis 6, dadurch gekennzeichnet, daß die Klebstoffschicht in einem Bereich von mindestens 80°C eine Sondenklebrigkeit von mindestens 75 p hat.

8. Klebeband nach einem der Ansprüche 1 bis 7, dadurch gekennzeichnet, daß die Tragschicht schwach klebfähige Oberflächen hat, so daß die Klebstoffschicht von der Tragschicht entfernt werden kann.

9. Klebeband nach einem der Ansprüche 1 bis 8, dadurch gekennzeichnet, daß die Klebstoffschicht aus in Abständen voneinander angeordneten Streifen des oder der Polymere besteht.

10. Wärmeaktivierbares Klebeband nach Anspruch 9, dadurch gekennzeichnet, daß die Zwischenräume zwischen den in Abständen voneinander angeordneten Streifen mit Streifen aus einem Haftkleber ausgefüllt sind.

11. Klebeband nach einem der Ansprüche 1 bis 10, dadurch gekennzeichnet, daß der Klebstoff als Füllstoff elektrisch leitende Teilchen in einer Menge von 0,1 bis 40 Vol.% der Klebstoffschicht enthält.

12. Klebeband nach einem der Ansprüche 1 bis 11, dadurch gekennzeichnet, daß die Tragschicht ein Kunststoffilm und zwischen diesem und der Klebstoffschicht eine die Haftung fördernde Grundierung vorgesehen ist.

13. Klebeband nach Anspruch 12, dadurch gekennzeichnet, daß der Kunststoffilm in der Wärme in der Längsrichtung schrumpffähig ist.

14. Klebeband nach einem der Ansprüche 1 bis 13, dadurch gekennzeichnet, daß die Tragschicht ein Kunststoffilm ist, auf dem unter der Klebstoffschicht und in Berührung mit ihr eine Mehrzahl von schmalen, parallelen, elektrisch leitenden Streifen vorgesehen sind.

15. Wärmeaktivierbares Klebeband nach Anspruch 14, dadurch gekennzeichnet, daß die Klebstoffschicht aus Streifen besteht, die über je einem der elektrisch leitenden Streifen angeordnet sind, daß die

15

**0 083 499**

Klebstoffstreifen und ihre Zwischenräume von einer füllstofffreien zweiten wärmeaktivierbaren Klebstoffschicht bedeckt sind, und daß die Dicke der elektrisch leitenden Teilchen annähernd der Gesamtdicke der beiden Klebstoffschichten entspricht.

16. Wärmeaktivierbares Klebeband nach einem der Ansprüche 1 bis 15, dadurch gekennzeichnet, daß die Tragschicht ein Kunststofffilm ist, unter jedem Klebstoffstreifen ein elektrisch leitender Streifen vorgesehen ist, und der Klebstoff als Füllstoff elektrisch leitende Teilchen in einer Menge von 0,1 bis 40 Vol.% der Klebstoffschicht enthält.

17. Wärmeaktivierbares Klebeband nach einem der Ansprüche 1 bis 11, dadurch gekennzeichnet, daß die Tragschicht eine elektrisch leitende Metallfolie ist.

18. Klebeband nach Anspruch 17, dadurch gekennzeichnet, daß die Klebstoffschicht mit einer Fläche der Metallfolie in Berührung steht und diese auf ihrer anderen Fläche mit einem schwach klebfähigen rückseitigen Überzug versehen ist.

19. Klebeband nach Anspruch 17 oder 18, dadurch gekennzeichnet, daß die Klebstoffschicht mit einer Deckschicht geschützt ist, die schwach klebfähige Oberflächen besitzt.

20. Klebeband nach Anspruch 19, dadurch gekennzeichnet, daß die Metallfolie auf jener Fläche der Klebstoffschicht, die durch die Wegnahme der Deckschicht freigelegt wird, ein Muster von Linien und/oder Punkten bildet.

21. Klebeband nach einem der Ansprüche 1 bis 11, dadurch gekennzeichnet, daß die Tragschicht aus einer Fasermaterialbahn besteht, mit deren Fasern der Klebstoff auf einer Oberfläche der Tragschicht mechanisch im Eingriff steht.

22. Klebeband nach Anspruch 21, dadurch gekennzeichnet, daß die Tragschicht mindestens teilweise aus gewebten Glasfasern oder aus einer Bahn aus einem Vliesstoff besteht.

23. Verfahren zum Herstellen eines in der Wärme klebfähigen Klebebandes, mit folgenden Schritten:

a) Durch Polymerisation einer Zusammensetzung, die Acrylsäuremonomer und funktionell reaktionsfähiges Organosilan in einer Menge von 0,2 bis 4 Teilen pro 100 Gewichtsteile Gesamtmonomer enthält, wird ein Acrylsäure-Silan-Interpolymer mit einer Einfriertemperatur von −10 bis 80°C erzeugt;

b) eine flexible, hitzebeständige Tragschicht wird mit einer Lösung des Interpolymers beschichtet, und

c) durch Trocknen der Beschichtung wird eine in der Wärme klebfähige Klebstoffschicht gebildet, die bei 20°C praktisch nicht klebfähig sit.

24. Verfahren zum Herstellen eines in der Wärme klebfähigen Klebebandes, mit folgenden Schritten:

a) Durch Polymerisieren einer Acrylsäuremonomer enthaltenden Zusammensetzung wird ein Acrylsäurepolymer mit einer Einfriertemperatur von −10 bis 80°C erzeugt;

b) das Acrylsäurepolymer wird mit funktionell reaktionsfähigem Organosilan in einer Menge von 0,2 bis 4 Teilen pro 100 Gewichtsteile des Polymers in Wechselwirkung gebracht;

c) eine flexible hitzebeständige Tragschicht wird mit einer Lösung des so erhaltenen Acrylsäure-Silan-Interpolymers beschichtet; und

d) durch Trocknen der Beschichtung wird eine in der Wärme klebfähige Klebstoffschicht gebildet, die bei 20°C praktisch nicht klebfähig ist.

## Revendications

1. Bande adhésive thermoactivable enroulable sur elle-même sous forme de rouleau par commodité de stockage et d'utilisation, et comprenant un support flexible thermorésistant et une couche adhésive qui est non collante ou faiblement collante à 20°C, ladite couche adhésive comprenant un ou plusieurs polymères acryliques de monomère d'ester acrylique, ladite bande adhésive étant caractérisée en ce que:

1) le monomère d'ester acrylique représente au moins 50 moles % du ou des polymères acryliques de la couche adhésive.

2) le ou les polymères acryliques ont une température Tg ou Tg à poids moyen de −10° à +80°C, et

3) la couche adhésive a

a) une valeur adhésive inférieure à 75 gf à 20°C

b) des valeurs adhésives d'au moins 75 gf dans une plage d'au moins 50°C, lesdites valeurs restant sensiblement constantes après 30 jours à 40°C, et

c) une valeur de cisaillement d'au moins 25 minutes à 65°C, ladite couche adhésive adhérant bien à un support propre par contact à nimporte quelle température dans ladite plage de 50°C,

le monomère d'ester acrylique étant défini comme un acrylate et/ou méthacrylate d'alkyle.

2. Bande adhésive suivant la revendication 1 dans laquelle ladite couche adhésive comprenant un interpolymère acrylique-silane d'un monomère primaire d'ester acrylique qu'on fait intéragir avec un organosilane en quantité d'au moins 0,2 partie pour 100 parties en poids du monomère total, ledit interpolymère acrylique-silane étant défini comme l'un des produits obtenus lorsque l'organosilane est interpolymérisé avec le monomère d'ester acrylique, avec ou sans autres monomères copolymérisables, ou lorsqu'on le fait réagir avec des groupes fonctionnels sur la structure d'un polymère acrylique.

3. Bande adhésive suivant la revendication 2, dans laquelle la quantité d'organosilane est de 0,5 à 4 parties pour 100 parties en poids de monomère total.

4. Bande adhésive suivant l'une quelconque des revendications 1 à 3, dans laquelle ladite couche adhésive comprend un ou plusieurs copolymères acryliques de monomères, dont jusqu'à 50 moles % sont

16

constituées par au moins un monomère copolymérisable choisi parmi les acides acrylique, méthacrylique, itaconique, maléique, l'anhydride maléique, les amides desdits acides, l'acrylonitrile, le méthacrylonitrile et la N-vinyl-2-pyrrolidone.

5. Bande adhésive suivant l'une quelconque des revendications 1 à 4, dans laquelle ledit monomère d'ester acrylique est choisi parmi les acrylates d'alkyle ayant de 1 à 8 atomes de carbone dans leurs groupes alkyle, les méthacrylates d'alkyle ayant de 1 à 8 atomes de carbone dans leurs groupes alkyle, les acrylates de bornyle, méthacrylates de bornyles, l'acrylate de 2-phénoxyéthyle, le méthacrylate de 2-phénoxyéthyle, les esters mono- et di-méthyliques et éthyliques de l'acide itaconique, les esters mono- et di-méthyliques et éthyliques de l'acide maléique.

6. Bande adhésive suivant l'une quelconque des revendications 1 à 5, dans laquelle le styrène, l'acétate de vinyle et le chlorure de vinyle représentent jusqu'à 5 moles % du total des monomères.

7. Bande adhésive suivant l'une quelconque des revendications 1 à 6, dans laquelle ladite couche adhésive a des valeurs adhésives d'au moins 75 gf sur une plage d'au moins 80°C.

8. Bande adhésive suivant l'une quelconque des revendications 1 à 7, dans laquelle le support a des surfaces à faible adhérence, de sorte que la couche adhésive puisse être retirée du support.

9. Bande adhésive suivant l'une quelconque des revendications 1 à 8, dans laquelle ladite couche adhésive est constituée par des bandes espacées du ou desdits polymères.

10. Bande adhésive thermoactivable suivant la revendication 9, dans laquelle les intervalles entre lesdites bandes espacées sont remplies avec des bandes d'adhésif adhérant par pression.

11. Bande adhésive suivant l'une quelconque des revendications 1 à 10, dans laquelle l'adhésif est chargé de particules électroconductrices représentant de 0,1 à 40% en volume de la couche adhésive.

12. Bande adhésive suivant l'une quelconque des revendications 1 à 11 dans laquelle le support est constitué par une pellicule en matière plastique et dans laquelle une couche primaire favorisant l'adhérence est interposée entre la couche adhésive et la pellicule plastique.

13. Bande adhésive suivant la revendication 12, dans laquelle la pellicule plastique est thermo-rétractable dans le sens de la longueur.

14. Bande adhésive suivant l'une quelconque des revendications 1 à 13, dans laquelle ledit support est une pellicule en matière plastique, et une pluralité d'étroites bandes électroconductrices parallèles recouvrent la pellicule plastique et sont sous-jacentes à la couche adhésive avec laquelle elles sont en contact.

15. Bande adhésive thermoactivable suivant la revendication 14, dans laquelle ladite couche adhésive se présente sous forme de bandes recouvrant chacune des bandes électroconductrices, et dans laquelle une deuxième couche adhésive thermoactivable non chargée recouvre les bandes adhésive et les intervalles qui séparent celles-ci, les particules électroconductrices ayant une épaisseur voisine de l'épaisseur totale des deux couches adhésives.

16. Bande adhésive thermoactivable suivant l'une quelconque des revendications 1 à 15, dans laquelle ledit support est une pellicule plastique, une bande électroconductrice est sous-jacente à chaque bande adhésive, et l'adhésif est chargé de particules électroconductrices représentant de 0,1 à 40% en volume de la couche adhésive.

17. Bande adhésive thermoactivable suivant l'une quelconque des revendications 1 à 11, dans laquelle ledit support est une pellicule métallique électroconductrice.

18. Bande adhésive suivant la revendication 17, dans laquelle la couche adhésive est en contact avec l'une des faces de la pellicule métallique, et dans laquelle un revêtement arrière de faible adhérence est appliqué sur l'autre face de la pellicule métallique.

19. Bande adhésive suivant l'une des revendications 17 ou 18, dans laquelle une feuille support ayant des surfaces à faible adhérence protège la couche adhésive.

20. Bande adhésive suivant la revendication 19, dans laquelle la pellicule métallique s'étend selon un tracé de lignes et/ou de points jusqu'à la surface de la couche adhésive, ledit tracé étant exposé lors de l'enlèvement de la feuille support.

21. Bande adhésive suivant l'une quelconque des revendications 1 à 11, dans laquelle ledit support est une feuille fibreuse, et l'adhésif est mécaniquement lié aux fibres sur l'une des faces du support.

22. Bande adhésive suivant la revendication 21, dans laquelle le support comprend des fibres de verre tissées ou une fauille de fibres non-tissées.

23. Procédé de fabrication d'une bande adhésive thermoactivable, comprenant les étapes de

a) polymérisation d'une composition comprenant un monomère d'ester acrylique et un organosilane réagissant fonctionnellement en quantité de 0,2 à 4 parties pour 100 parties en poids de monomère total, pour produire un interpolymère acrylique-silane ayant une température Tg de −10° à +80°C,

b) dépôt d'une solution de l'interpolymère sur un support flexible thermorésistant et,

c) séchage du revêtement résultant pour obtenir une couche adhésive thermoactivable qui est virtuellement non collante à 20°C.

24. Procédé de fabrication d'une bande adhésive thermoactivable comprenant les étapes de

a) polymérisation d'une composition comprenant un monomère d'ester acrylique pour obtenir un polymère acrylique ayant une température Tg de −10° à 80°C;

b) réaction du polymère acrylique avec un organosilane fonctionnellement réactif en quantité de 0,2 à 4 parties par 100 parties en poids de polymère,

17

c) dépôt d'une solution de l'interpolymère acrylique/silane, qui en résulte, sur un support flexible thermorésistant, et

d) séchage du revêtement résultant pour obtenir une couche adhésive thermoactivable qui est virtuellement non collante à 20°C.

*FIG.1*

*FIG. 2*

*FIG. 3*

*FIG. 4*

*FIG. 5*

67 62

**FIG. 6**

73A 72A

70

73B 72B 76 78 79

**FIG. 7**